# EUROPEAN PATENT APPLICATION

(11) **EP 4 700 400 A1**
(43) Date of publication of application: **25.02.2026**
(21) Application number: 25195391.5
(22) Date of filing: 12.08.2025
(51) Int. Cl.: G01R 31/28, G01R 31/317, G06F 11/263, G06F 11/22

(54) **TEST DEVICE, TEST SYSTEM, TEST METHOD, AND TEST APPARATUS**

(30) Priority: 15.08.2024 CN 202411133596
(71) Applicant: Ant Group Co., Ltd., Hangzhou City, Zhejiang Province (CN)
(72) Inventor: FU, Wei, Hangzhou (CN); HUANG, Lin, Hangzhou (CN); JIAN, Yunding, Hangzhou (CN)
(74) Representative: Goddar, Heinz J.

(57) **Abstract**

The present specification discloses a test device, a test system, a test method, and a test apparatus. The test device provided in the present specification includes an FPGA chip capable of controlling a target power supply that supplies power to an MCU under test. In practice, different test logic programs can be configured in the FPGA chip based on actual needs, to satisfy a need of flexibly testing different types of MCUs under test. In addition, the FPGA chip in the test device can be used to generate a high-frequency clock signal, to ensure time accuracy when voltage glitch faults are injected into the MCU under test, so as to further ensure a test effect for the MCU under test.

## Description

### TECHNICAL FIELD

The present application relates to the field of electronic technologies, and in particular, to a test device, a test system, a test method, and a test apparatus.

### BACKGROUND

Currently, personal consumer electronic products have developed rapidly, enabling the personal consumer electronic products to provide users with a variety of functions such as artificial intelligence, data analysis, online shopping, and personal information protection, thereby greatly facilitating users' daily lives.

Most personal consumer electronic products include microcontroller unit (MCU) chips, and various functions of the personal consumer electronic products can be implemented through the MCU chips. However, these MCU chips probably have certain vulnerabilities in their design and manufacturing processes. If these vulnerabilities cannot be detected in a timely and effective means, not only users' experience when using personal consumer electronic products is affected, but in severe cases, users' personal privacy data is also disclosed, thereby exposing the users to the risk of personal information leakage.

Therefore, how to effectively detect vulnerabilities existing in MCU chips is a technical problem to be solved.

### SUMMARY

Implementations of the present specification provide a test device, a test system, a test method, and a test apparatus, to partially solve a problem in the existing technologies that whether a microcontroller unit (MCU) has a vulnerability cannot be tested effectively.

The following technical solutions are used in implementations of the present specification:

An implementation of the present specification provides a test device, and the test device includes a field programmable gate array (FPGA) chip and a power supply, where the power supply is configured to supply power to the test device, and the FPGA chip is configured to: receive a test instruction, generate a control signal based on the test instruction, and control, based on the control signal, a target power supply that supplies power to an MCU under test to generate a voltage glitch, so as to test the MCU under test.

Further, in some implementations, the test device further includes a programmable power supply, where the programmable power supply is configured to supply power to the MCU under test.

Further, in some implementations, the FPGA chip is configured to control, based on the control signal, the programmable power supply to generate the voltage glitch.

Further, in some implementations, the test device further includes an MCU interface; and the FPGA chip is configured to send a target signal to the MCU under test through the MCU interface, where the target signal includes at least one of a restart signal for restarting the MCU under test or a reset signal for resetting the MCU under test.

Further, in some implementations, the FPGA chip is configured to generate the control signal by using the MCU interface, so as to control, based on the control signal, the target power supply to generate the voltage glitch.

Further, in some implementations, the test device further includes a transmission interface, and the FPGA chip is configured to receive, through the transmission interface, a test instruction that is sent by a host computer.

Further, in some implementations, the test device further includes a data transmission unit, where the FPGA chip is configured to: obtain, by using the data transmission unit from the MCU under test, response data generated by the MCU under test in response to the voltage glitch generated by the target power supply, and send the response data to the host computer by using the data transmission unit.

Further, in some implementations, the test device further includes a storage unit; the storage unit is configured to store at least a part of the response data when a data size of the response data exceeds a threshold data size; and the FPGA chip is configured to: read data stored in the storage unit, and send the read data to the host computer through the transmission interface.

An implementation of the present specification provides a test system including a host computer, a test device, and an MCU under test, where the test device includes an FPGA chip, a power supply, and a transmission interface, and the power supply is configured to supply power to the test device; the host computer is configured to send a test instruction to the FPGA chip in the test device through the transmission interface; and the test device is configured to: receive the test instruction, generate a control signal based on the test instruction by using the FPGA chip, and control, based on the control signal, a target power supply that supplies power to the MCU under test to generate a voltage glitch, so as to test the MCU under test.

Further, in some implementations, the test device further includes a data transmission unit; and the test device is configured to: obtain, by using the data transmission unit from the MCU under test, response data generated by the MCU under test in response to the voltage glitch generated by the target power supply, and send the response data to the host computer by using the data transmission unit through the FPGA chip.

Further, in some implementations, the test device further includes a storage unit; the storage unit is configured to store at least a part of the response data when a data size of the response data exceeds a threshold data size; and the FPGA chip is configured to: read data stored in the storage unit, and send the read data to the host computer through the transmission interface.

Further, in some implementations, the host computer is configured to send a pre-stored test logic program to the test device through the transmission interface before sending the test instruction; and the test device stores the test logic program in the FPGA chip, so that when the test instruction is received, a test task for the MCU under test is executed by using the test logic program.

An implementation of the present specification provides a test method. The method is applied to an FPGA chip disposed in a test device, and includes: receiving a test instruction; generating a control signal based on the test instruction; and controlling, based on the control signal, a target power supply that supplies power to an MCU under test to generate a voltage glitch, so as to test the MCU under test.

An implementation of the present specification provides a test apparatus. The apparatus is disposed in a test device, and includes: a receiving module, configured to receive a test instruction; a generation module, configured to generate a control signal based on the test instruction; and a control module, configured to control, based on the control signal, a target power supply that supplies power to an MCU under test to generate a voltage glitch, so as to test the MCU under test.

An implementation of the present specification provides a computer-readable storage medium. The storage medium stores a computer program, and when the computer program is executed by a processor, the above test method is implemented.

At least one of the above technical solutions used in the present specification can achieve the following beneficial effects:

The test device provided in implementations of the present specification includes an FPGA chip and a power supply. The power supply supplies power to the test device. The FPGA chip can receive a test instruction and then generate a control signal based on the test instruction, and control, based on the control signal, a target power supply that supplies power to an MCU under test to generate a voltage glitch, so as to test the MCU under test.

It can be seen from the above test device that the test device provided in the present specification includes an FPGA chip capable of controlling the target power supply that supplies power to the MCU under test. In practice, different test logic programs can be configured in the FPGA chip based on actual needs, to satisfy a need of flexibly testing different types of MCUs under test. In addition, the FPGA chip in the test device can be used to generate a high-frequency clock signal, to ensure time accuracy when voltage glitch faults are injected into the MCU under test, so as to further ensure a test effect for the MCU under test.

### BRIEF DESCRIPTION OF DRAWINGS

FIG. 1 is a schematic diagram illustrating a test device according to the present specification;
FIG. 2 is a schematic diagram illustrating a test device including an MCU interface according to the present specification;
FIG. 3 is a schematic diagram illustrating a test device including a user key according to the present specification;
FIG. 4 is a schematic diagram illustrating a test device including a transmission interface according to the present specification;
FIG. 5 is a schematic diagram illustrating a test device including a data transmission unit according to the present specification;
FIG. 6 is a schematic diagram illustrating a test device including a storage unit according to the present specification;
FIG. 7 is a schematic diagram illustrating a test device including a clock function component according to the present specification;
FIG. 8 is a schematic flowchart illustrating a test method according to the present specification; and
FIG. 9 is a schematic diagram illustrating a test apparatus according to the present specification.

### DESCRIPTION OF EMBODIMENTS

To make the objectives, technical solutions, and advantages of the present specification clearer, the following clearly and comprehensively describes the technical solutions in the present specification with reference to specific implementations of the present specification and corresponding accompanying drawings. Clearly, the described implementations are merely some rather than all of the implementations of the present specification. All other implementations obtained by those of ordinary skill in the art based on the implementations of the present specification without innovative efforts all fall within the protection scope of the present specification.

Currently, to prevent a vulnerability in a microcontroller unit (MCU) chip in a personal consumer electronic product from causing adverse impact, the MCU chip in the personal consumer electronic product usually needs to be tested, and then the vulnerability in the MCU chip is fixed based on a test result. A specific test method is typically voltage glitch fault injection. Voltage glitch fault injection refers to the deliberate introduction of brief voltage fluctuations (i.e., "glitches") on a power supply line of a device under test, in order to observe behavioral reactions of the device under test.

A voltage glitch refers to a sudden and brief anomaly in a signal, which may be a spike or a dip of the signal. In the case of a voltage glitch, this typically refers to a momentary rise or drop in a power supply voltage, and such a phenomenon can last from a few nanoseconds to several microseconds.

However, once a device under test is affected by a voltage glitch, various abnormal situations may occur. For example, because an MCU under test is affected by the voltage glitch, encrypted firmware or code stored in the MCU under test may become readable or obtainable. For another example, if the MCU under test stores a key required for encrypting data, because the MCU under test is affected by the voltage glitch, a key part stored in the MCU under test may be completely disclosed. For another example, because the MCU under test is affected by the voltage glitch, errors may be caused to the MCU under test in a process of performing key computation.

Therefore, by means of voltage glitch fault injection, it is possible to test whether the MCU under test has an abnormal situation when affected by the voltage glitch, to determine whether any vulnerability exists in the MCU under test. Once such vulnerability is determined, the vulnerability of the MCU under test can be fixed based on characteristics of each vulnerability, thereby ensuring that the MCU under test can still maintain its security and reliability even under the impact of the voltage glitch. An abnormal state in the above example is used as an example. In a manner of fixing a vulnerability, it is expected that under impact of the voltage glitch, the MCU under test can still not disclose a key required for encrypting data, encrypted firmware or code is still unreadable or unobtainable, no error occurs in a process of performing key computation, etc.

However, a current voltage glitch fault injection method faces numerous issues. For example, when an Atmel microcontroller is used to implement voltage glitch fault injection, because a core frequency of the Atmel microcontroller is too low to achieve a precise delay, which in turn makes it difficult to ensure time accuracy during voltage glitch fault injection, a final testing result is affected. Furthermore, during voltage glitch fault injection on the MCU under test, an existing method lacks features such as a high sampling rate and high resolution. As a result, determining an exact point of voltage glitch injection requires a device such as an oscilloscope to capture a voltage waveform, making an entire fault injection process cumbersome and inefficient. Additionally, the need for the extra device (e.g., the oscilloscope) significantly increases overall costs of the entire fault injection process.

Therefore, the present specification provides a test device. The test device includes an FPGA chip capable of controlling a target power supply that supplies power to an MCU under test. In practice, different test logic programs can be configured in the FPGA chip based on actual needs, to implement a need of flexibly testing different types of MCUs under test. In addition, the FPGA chip in the test device can be used to generate a high-frequency clock signal, to ensure time accuracy when voltage glitch faults are injected into the MCU under test, so as to further ensure a test effect for the MCU under test.

A test device provided in the present specification is to be described in detail below.

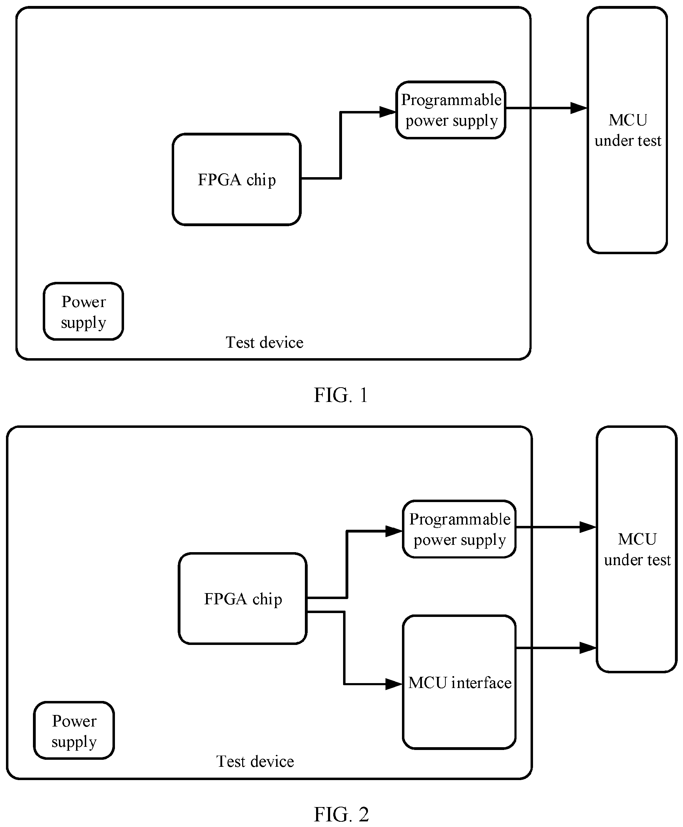

FIG. 1 is a schematic diagram illustrating a test device according to the present specification.

The test device shown in FIG. 1 includes a power supply and a field programmable gate array (FPGA) chip. The power supply is mainly configured to supply power to the test device, and the FPGA chip is configured to receive a test instruction, and generate a corresponding control signal based on the test instruction, to control, based on the control signal, a target power supply that supplies power to an MCU under test to generate a voltage glitch, so as to test the MCU under test.

In this process, the target power supply configured to supply power to the MCU under test can be an external power supply disposed outside the test device. As such, a line can be disposed between the FPGA chip and the external power supply. The FPGA chip controls, based on the generated control signal and based on the line, the external power supply to generate a voltage glitch, thereby attempting to trigger an abnormal condition in the MCU under test.

Certainly, a dedicated target power supply for supplying power to the MCU under test can also be disposed in the test device, and the target power supply can be a programmable power supply shown in FIG. 1.

The programmable power supply is a power supply device that can control an output voltage and an output current based on an external signal or command. The programmable power supply is capable of providing high-precision voltage and current regulation and stable output performance. Therefore, in the present specification, the FPGA chip can control, based on the control signal, the programmable power supply to generate the voltage glitch, so as to test the MCU under test.

In addition to the methods mentioned above, actually, the target power supply can generate a voltage glitch in another method. Specifically, the test device provided in the present specification can further include an MCU interface. The FPGA chip in the test device can output the control signal through the MCU interface, so as to control the target power supply, as shown in FIG. 2.

FIG. 2 is a schematic diagram illustrating a test device including an MCU interface according to the present specification.

A process in which the FPGA chip generates the control signal through the MCU interface in FIG. 2 can be specifically as follows: The FPGA chip transmits a parameter used to generate the control signal to the MCU interface, and the MCU interface can generate the corresponding control signal based on the obtained parameter.

However, the MCU interface can further transmit the above control signal to the target power supply that supplies power to the MCU under test, so as to inject a voltage glitch fault into the MCU under test. If the target power supply is the programmable power supply mentioned above (but this programmable power supply can also be an external power supply disposed outside the test device), after the MCU interface sends the control signal to the programmable power supply, the programmable power supply is controlled to generate a voltage glitch. If the target power supply is a common power supply disposed outside the test device, the control signal generated by the MCU interface can be considered as a level signal that can trigger the target power supply to generate a voltage glitch.

In addition to generating the above control signal, the above MCU interface can further generate a target signal used for controlling the MCU under test. The target signal mentioned herein can be a signal such as a restart signal for restarting the MCU under test and a reset signal for resetting the MCU under test.

The restart signal mentioned herein is used to restore the MCU under test to a known initial state. For example, after being restarted, an internal register in the MCU under test is set to a default value. For another example, a clock source of the MCU under test can be switched back to default setting through restarting, to ensure that the MCU under test runs at a correct clock frequency.

The reset signal is mainly used to reset a state of the MCU under test. For example, an internal register in the MCU under test is initialized, that is, the internal register in the MCU under test is reset to a default state or a predefined state, so that a processor in the MCU under test executes code from a start address of a program. For another example, a state flag is cleared, that is, all flags in a state register in the MCU under test are cleared, so as to ensure that the processor in the MCU under test is in a known initial state. For another example, an I/O port of the MCU under test is initialized, that is, the I/O port of the MCU under test is reset to a default state or a predefined state.

Signals listed above can be used in a process of testing the MCU under test. For example, after a voltage glitch fault is injected into the MCU under test, a state of the MCU under test can be restored to an initial state by using the restart signal, and then a next voltage glitch fault is injected into the MCU under test.

It should be noted that only two types of signals of different functions are listed above. In practice, there can be other signals used to control the MCU under test, which are not described in detail as examples herein.

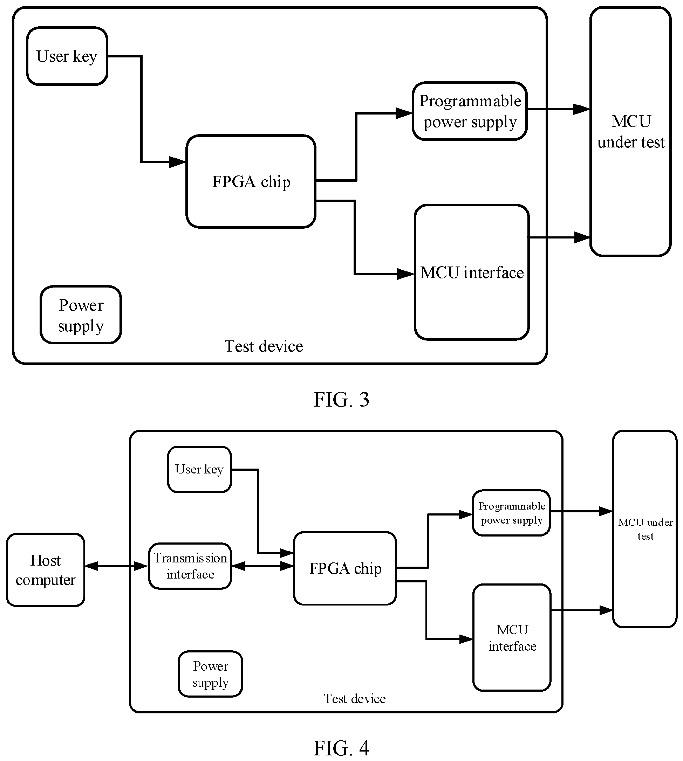

In the present specification, the test instruction received by the FPGA chip can be generated in a plurality of methods. For example, the test device can include a user key, and the user key can be used to generate the test instruction, as shown in FIG. 3.

FIG. 3 is a schematic diagram illustrating a test device including a user key according to the present specification.

In the test device shown in FIG. 3, when a user touches the user key, the test device can generate a test instruction, and transmit the test instruction to the FPGA chip through an internal line in the test device. As such, the test instruction generated by touching the user key can be considered as a signal for triggering the FPGA chip to inject a voltage glitch fault. To be specific, after receiving the test instruction, the FPGA chip can inject a voltage glitch fault based on a test logic program stored inside the FPGA chip. When a plurality of test logic programs applicable to different MCUs are stored inside the FPGA chip, different MCUs can still be tested in this method.

It should be noted that in the present specification, a printed circuit board (PCB) in the test device includes a plurality of pins (a pin is a metal contact on the PCB that is connected to a component). Therefore, a plurality of keys can be disposed on the PCB in the test device based on actual needs, and different keys can implement different functions. Therefore, the above user key is one of a variety of keys disposed on the PCB in the test device, and is used to trigger the FPGA chip to inject a voltage glitch fault.

In addition to the above method, the FPGA chip can be triggered, in another method, to inject a voltage glitch fault. Specifically, the test device provided in the present specification can further include a transmission interface, and the transmission interface can receive a test instruction sent by a host computer, as shown in FIG. 4.

FIG. 4 is a schematic diagram illustrating a test device including a transmission interface according to the present specification.

A host computer is further shown in FIG. 4, and the host computer generally refers to a computer system with a higher-layer control and management function. The host computer is mainly responsible for monitoring, coordinating, and managing a workflow of an entire system, and can be used for data processing, analysis, decision-making, and sending a control instruction to a lower computer (a subordinate device or a subsystem). In the present specification, the host computer can be in a plurality of specific forms, such as a device in a hardware form such as a desktop computer or a server, or can be software in a form such as a client or an application installed in a hardware device.

Further, the host computer can generate a test instruction, and send the test instruction to the FPGA chip through the transmission interface, so as to trigger the FPGA chip to inject a voltage glitch fault. The host computer can be triggered in a plurality of methods to generate the test instruction. For example, when detecting that the user performs a test operation on the MCU under test, the host computer can generate a test instruction for the MCU under test. For another example, the host computer can first send a detection signal to the test device to detect whether the MCU under test is connected to the test device, and can generate a test instruction when determining that the MCU under test is connected to the test device.

In a process of injecting a voltage glitch fault, the MCU under test generates corresponding response data in response to the voltage glitch. The response data mentioned herein can be understood as data that can be obtained from the MCU under test, for example, a power voltage waveform (the power voltage waveform can reflect a change of a power voltage before and after the voltage glitch is injected, so as to understand an amplitude and duration of the voltage glitch), an output signal of the MCU under test (which is mainly used to detect whether the MCU under test has abnormal behavior or information disclosure after being affected by the voltage glitch), or data read from a storage unit of the MCU under test (which is mainly used to check data content stored in a non-volatile memory such as a flash or an EEPROM, to determine whether data is modified or erased after the MCU under test is affected by the voltage glitch).

Therefore, the above response data can be used to analyze whether the MCU under test has a vulnerability. Therefore, the response data can be sent to the host computer to analyze, by using the host computer, the vulnerability existing in the MCU under test.

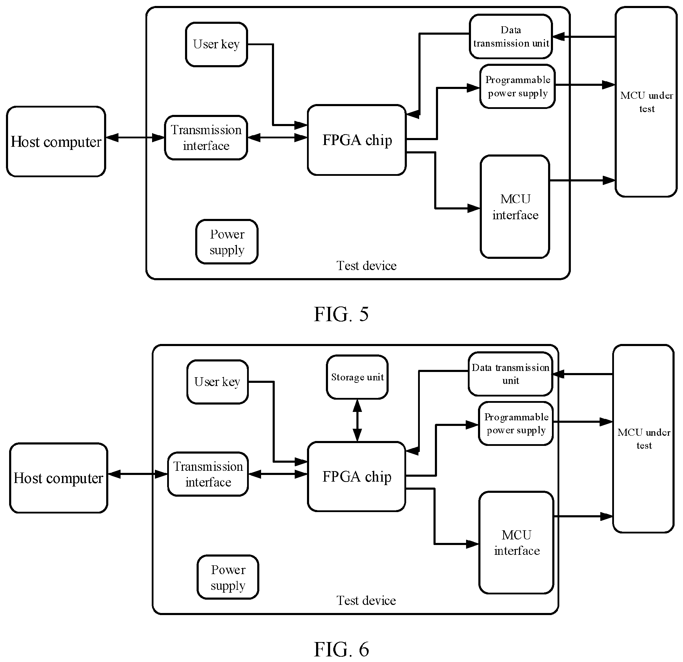

Therefore, the test device provided in the present specification further includes a data transmission unit. The data transmission unit is mainly configured to transmit to the host computer via the test device the response data generated by the MCU under test in response to the voltage glitch, as shown in FIG. 5.

FIG. 5 is a schematic diagram illustrating a test device including a data transmission unit according to the present specification.

It can be seen from FIG. 5 that the response data generated by the MCU under test in response to the voltage glitch is sent to the FPGA chip in the test device by using the data transmission unit, and then sent to the host computer through the transmission interface.

The data transmission unit mentioned in the present specification can be an analog-to-digital converter (ADC), and the ADC is a hardware device that can convert continuously changing analog signals into discrete digital signals. Certainly, the data transmission unit can also be in another form, provided that a function of obtaining the response data from the MCU under test and sending the response data to the FPGA chip can be implemented.

In addition, the transmission interface mentioned above can also be in a plurality of forms. For example, the transmission interface can be an interface that uses a Universal Serial Bus (USB) 2.0 protocol, an interface that uses a USB3.0 protocol, etc. The interface that uses the USB3.0 protocol can be preferably used, so that the host computer can quickly deliver the test instruction to the FPGA chip, and can quickly send response data obtained by the FPGA chip to the host computer for analysis and processing, thereby further improving test efficiency for the MCU under test.

It should be noted that, in practice, the MCU under test can generate response data with a relatively large data amount in response to the voltage glitch. The relatively large data amount can be understood as exceeding a maximum amount of data that the FPGA chip can send in a single data transmission. As such, the test device needs to first store some response data before sending data for a plurality of times, so as to send all response data generated by the MCU under test in response to the voltage glitch to the host computer, as shown in FIG. 6.

FIG. 6 is a schematic diagram illustrating a test device including a storage unit according to the present specification.

The test device shown in FIG. 6 includes a storage unit. The storage unit can store at least some response data when a data size of the response data exceeds a threshold data size. As such, in a process of sending the response data, the FPGA chip can read data from the storage unit, and send the read data to the host computer through the transmission interface in FIG. 6.

The above storage unit can be in a plurality of specific forms. For example, the storage unit can be a memory such as DDR3 or DDR4, which can be specifically determined based on actual needs.

It can be seen from the above test device that the test device provided in the present specification includes the FPGA chip capable of controlling the target power supply that supplies power to the MCU under test. In practice, different test logic programs can be configured in the FPGA chip based on actual needs, to implement a need of flexibly testing different types of MCUs under test.

In addition, a high-frequency clock signal (for example, a clock signal with a maximum of 400 M and a minimum clock period of 2.5 ns) can be generated by using the FPGA chip (in cooperation with an internal phase-locked loop in the FPGA chip) in the test device, thereby ensuring time accuracy of voltage glitch fault injection into the MCU under test, and further ensuring a test effect of the MCU under test.

Further, via the above data transmission unit, a sampling rate and resolution of data can be improved, so that a fault injection point of a voltage glitch can be quickly determined by using collected data. For example, when the data transmission unit is an ADC, data can be collected at a sampling rate of 500 M to obtain data with resolution of 12 bits, so that a fault injection point can be quickly determined.

Therefore, in addition to the response data generated by the MCU under test in response to the voltage glitch, the above data transmission unit can collect, before the MCU under test is affected by the voltage glitch, a power voltage signal of the MCU under test, so as to determine a specific voltage glitch fault injection point.

It should be noted that the internal phase-locked loop mentioned above is actually an important circuit used for frequency synthesis and clock management. The internal phase-locked loop can implement functions such as clock signal frequency enhancement (actually, a signal amplification effect can be implemented), clock source switching (in which switching between different clock sources can be smoothly implemented, for example, switching from a low-frequency RC oscillator to a high-frequency crystal oscillator), and frequency stability (which can maintain a stable clock signal frequency, and even if a frequency of an external clock source fluctuates, the internal phase-locked loop can be controlled by means of feedback, to make output frequencies consistent). Therefore, it can be seen herein that because the internal phase-locked loop can amplify a clock signal, the FPGA chip can generate a high-frequency clock signal.

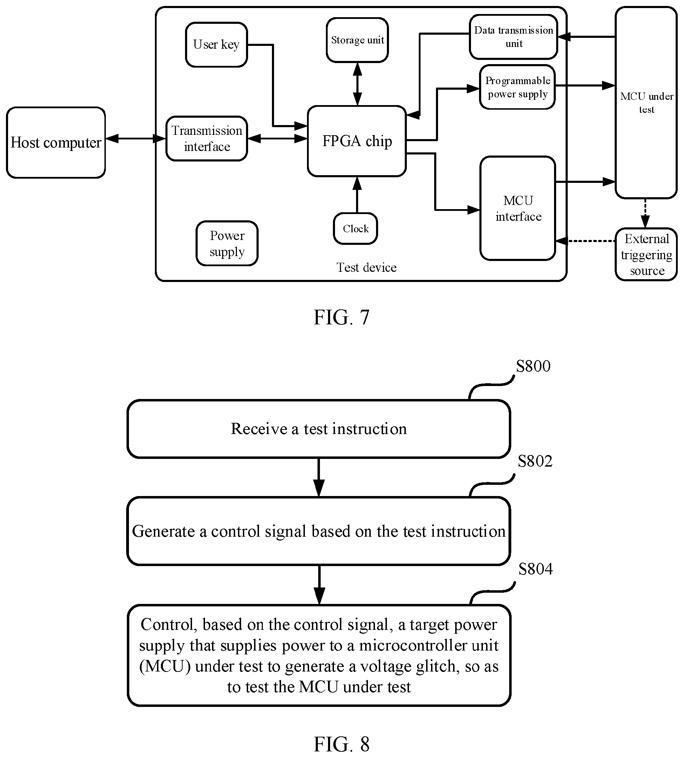

In addition, in the present specification, the test device can further include a component that implements a clock function, as shown in FIG. 7.

FIG. 7 is a schematic diagram illustrating a test device including a clock function component according to the present specification.

A clock shown in FIG. 7 is mainly used to implement the following functions: a synchronous operation (a clock signal provides a necessary timing reference for all synchronous logic circuits (such as a flip-flop and a register) in the FPGA chip, and these circuits update states on a rising edge or a falling edge of the clock, ensuring correct data transfer and storage in a circuit), timing control (a clock signal determines a rate of processing data inside the FPGA chip, and all timing logic operations including data reading, processing, and writing need to be completed within a clock cycle), a clock distribution network (the FPGA chip contains a dedicated clock distribution network configured to efficiently and uniformly allocate clock signals to every logic unit that requires the clock signal, ensuring signal integrity and minimizing clock skew), and these functions can be understood as essential for maintaining the normal operation of the FPGA chip.

In addition to the test device shown in the above one or more implementations, the present specification further provides a test system. The test system includes a host computer, a test device, and an MCU under test. The test device can include an FPGA chip, a power supply, and a transmission interface, and the power supply is configured to supply power to the test device.

The host computer in the test system can send a test instruction to the FPGA chip in the test device through the transmission interface in the test device, and the FPGA chip in the test device can generate a corresponding control signal based on the received test instruction, and control, based on the control signal, a target power supply that supplies power to the MCU under test to generate a voltage glitch, so as to test the MCU under test. A basic process of injecting a voltage glitch fault by using the test system is described in detail above. Details are omitted herein for simplicity.

In practice, there are a plurality of models and a plurality of types of MCUs. When voltage glitch faults are injected into different MCUs, different voltage glitches need to be generated. Therefore, in the present specification, different test logic programs can be programmed in the FPGA chip based on actual needs. The programmed test logic programs need to be adapted to the MCU under test.

It should be emphasized that the test logic programs stored in the FPGA chip in the test device can be programmed in the FPGA chip by using the host computer before a test task for the MCU under test is executed. In other words, when not executing the test task, the test device may not store the test logic program, but stores, before executing the test task, a test logic program required for executing the test task in the FPGA chip by using the host computer.

Therefore, the host computer can store test logic programs suitable for different MCUs. These test logic programs can be configured on the host computer by the user based on actual needs. As such, the test logic program is actually managed in the host computer without programming specifically for the FPGA chip. After the host computer is connected to the test device, only simple operations are required to synchronize a required test logic program to the FPGA chip so as to inject a voltage glitch fault.

In addition, as mentioned above, the PCB board in the test device includes a plurality of pins for function extension, so that the test device can be connected to some external triggering sources. For example, a device such as an oscilloscope, a logic analyzer, or a digital signal generator can be externally connected to the test device, as shown in FIG. 7. These devices can collect data of the MCU under test, and then send the collected data to the FPGA chip through the MCU interface in FIG. 7, so as to perform an operation such as determining a voltage glitch fault injection point.

In the present specification, to further improve test efficiency, when executing a test task to determine whether data stored in the MCU under test (the stored data can be encrypted private data or firmware, where the firmware refers to a program stored in a memory of the MCU under test) may be disclosed due to an existing vulnerability, the host computer can store space information of memory space occupied by the data stored in the MCU under test. The space information reflects a size of the memory space occupied by the data stored in the MCU under test and a storage location. For example, if the data stored in the MCU under test is firmware, the space information can be a firmware length. The space information can be entered in advance in the host computer based on device information of the MCU under test.

On this basis, the host computer can send the space information to the FPGA chip through the above transmission interface, and the FPGA chip can perform, based on the space information, voltage glitch fault injection on the data stored in the MCU under test. As such, the FPGA chip can be prevented from injecting a voltage glitch fault into an empty sector of the memory in the MCU under test, thereby effectively improving test efficiency for the MCU under test.

In addition, it should be noted that the FPGA chip in the test device has relatively high security, making it difficult for the data stored in the FPGA chip to be disclosed. Therefore, the test device or the test system provided in the present specification can ensure data security when a test task is executed for the MCU under test.

The present specification further provides a test method. The test method is mainly applied to the FPGA chip in the above test device, as shown in FIG. 8.

FIG. 8 is a schematic flowchart illustrating a test method according to the present specification. The test method specifically includes the following steps:
S800: Receive a test instruction.
S802: Generate a control signal based on the test instruction.
S804: Control, based on the control signal, a target power supply that supplies power to an MCU under test to generate a voltage glitch, so as to test the MCU under test.

The above method can be implemented by using a program deployed in the FPGA chip. However, a process in which the test device performs voltage glitch fault injection by using the FPGA chip is described in detail in the above content, and details are omitted for simplicity herein.

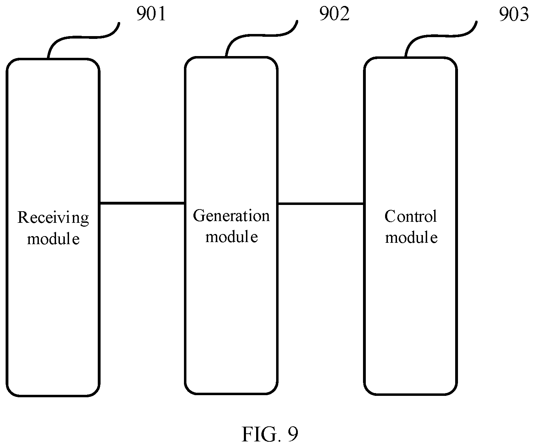

The test method provided in one or more implementations of the present specification is described above. Based on the same idea, the present specification further provides a corresponding test apparatus, as shown in FIG. 9.

FIG. 9 is a schematic diagram illustrating a test apparatus according to the present specification. The apparatus includes: a receiving module 901, configured to receive a test instruction; a generation module 902, configured to generate a control signal based on the test instruction; and a control module 903, configured to control, based on the control signal, a target power supply that supplies power to an MCU under test to generate a voltage glitch, so as to test the MCU under test.

The above apparatus implementation corresponds to the method implementations. For specific descriptions, references can be made to some of the descriptions of the method implementations. Details are omitted herein for simplicity. The apparatus implementation is obtained based on the corresponding method implementations, and has the same technical effects as the corresponding method implementations. For specific descriptions, references can be made to the corresponding method implementations.

An implementation of the present specification further provides a computer storage medium. The computer storage medium can store a plurality of instructions, and the instructions are adapted to be loaded by a processor and to perform the method in the implementation shown in FIG. 8. For a specific execution process, references can be made to the detailed descriptions in the implementation shown in FIG. 8. Details are omitted herein for simplicity.

The present specification further provides a computer program product. The computer program product stores at least one instruction. The at least one instruction is loaded by a processor to perform the method in the implementation shown in FIG. 8. For a specific execution process, references can be made to specific descriptions of the implementation shown in FIG. 8. Details are omitted herein for simplicity.

Certainly, in addition to a software implementation, the present specification does not exclude other implementations, such as a logic device or a combination of software and hardware. In other words, an execution entity of the following processing flow is not limited to each logic unit, but can also be hardware or logic devices.

In the 1990s, whether a technical improvement is a hardware improvement (for example, an improvement to a circuit structure such as a diode, a transistor, or a switch) or a software improvement (an improvement to a method procedure) can be clearly distinguished. However, as technologies develop, current improvements to many method procedures can be considered as direct improvements to hardware circuit structures. A designer usually programs an improved method procedure into a hardware circuit, to obtain a corresponding hardware circuit structure. Therefore, a method procedure can be improved by using a hardware entity module. For example, a programmable logic device (PLD) (for example, a field programmable gate array (FPGA)) is such an integrated circuit, and a logical function of the PLD is determined by a user through device programming. The designer performs programming to "integrate" a digital system to a PLD without requesting a chip manufacturer to design and produce an application specific integrated circuit chip. In addition, at present, instead of manually manufacturing an integrated circuit chip, this type of programming is mostly implemented by using "logic compiler" software. The software is similar to a software compiler used to develop and write a program. Original code needs to be written in a particular programming language for compilation. The language is referred to as a hardware description language (HDL). There are many HDLs, such as the Advanced Boolean Expression Language (ABEL), the Altera Hardware Description Language (AHDL), Confluence, the Cornell University Programming Language (CUPL), HDCal, the Java Hardware Description Language (JHDL), Lava, Lola, MyHDL, PALASM, and the Ruby Hardware Description Language (RHDL). The very-high-speed integrated circuit hardware description language (VHDL) and Verilog are most commonly used. A person skilled in the art should also understand that a hardware circuit that implements a logical method procedure can be readily obtained once the method procedure is logically programmed by using the several described hardware description languages and is programmed into an integrated circuit.

A controller can be implemented by using any appropriate method. For example, the controller can be a microprocessor or a processor, or a computer-readable medium that stores computer-readable program code (such as software or firmware) that can be executed by the microprocessor or the processor, a logic gate, a switch, an application-specific integrated circuit (ASIC), a programmable logic controller, or an embedded microprocessor. Examples of the controller include but are not limited to the following microprocessors: ARC 625D, Atmel AT91SAM, Microchip PIC18F26K20, and Silicone Labs C8051F320. The memory controller can also be implemented as a part of the control logic of the memory. A person skilled in the art also knows that, in addition to implementing the controller by using only the computer-readable program code, logic programming can be performed on method steps to enable the controller to implement the same function in forms of the logic gate, the switch, the application-specific integrated circuit, the programmable logic controller, the embedded microcontroller, etc. Therefore, the controller can be considered as a hardware component, and an apparatus included in the controller for implementing various functions can also be considered as a structure in the hardware component. Alternatively, the apparatus configured to implement various functions can even be considered as both a software module implementing the method and a structure in the hardware component.

Systems, apparatuses, modules, or units that are described in the above implementations can be for example implemented by using a computer chip or an entity, or by using a product with a certain function. A typical implementation device is a computer. Specifically, the computer can be, for example, a personal computer, a laptop computer, a cellular phone, a camera phone, a smartphone, a personal digital assistant, a media player, a navigation device, an email device, a game console, a tablet computer, or a wearable device, or a combination of any of these devices.

For ease of description, the above apparatus is described by dividing functions into various units. Certainly, when the present specification is implemented, a function of each unit can be implemented in one or more pieces of software and/or hardware.

A person skilled in the art should understand that the implementations of the present specification can be provided as methods, systems, or computer program products. Therefore, the present specification can use a form of hardware only implementations, software only implementations, or implementations with a combination of software and hardware. Moreover, the present specification can use a form of a computer program product that is implemented on one or more computer-usable storage media (including but not limited to a disk memory, a CD-ROM, an optical memory, etc.) that include computer-usable program code.

The present specification is described with reference to the flowcharts and/or block diagrams of the methods, the devices (systems), and the computer program products based on the implementations of the present specification. It should be understood that computer program instructions can be used to implement each procedure and/or each block in the flowcharts and/or the block diagrams and a combination of a procedure and/or a block in the flowcharts and/or the block diagrams. These computer program instructions can be provided for a general-purpose computer, a dedicated computer, an embedded processor, or a processor of another programmable data processing device to generate a machine, so the instructions executed by the computer or the processor of the another programmable data processing device generate an apparatus for implementing a specific function in one or more processes in the flowcharts and/or in one or more blocks in the block diagrams.

Alternatively, these computer program instructions can be stored in a computer-readable storage that can instruct a computer or another programmable data processing device to work in a specific manner, so the instructions stored in the computer-readable storage generate an artifact that includes an instruction apparatus. The instruction apparatus implements a specific function in one or more procedures in the flowcharts and/or in one or more blocks in the block diagrams.

Alternatively, these computer program instructions can be loaded onto a computer or another programmable data processing device, so that a series of operations and steps are performed on the computer or the another programmable device, to generate computer-implemented processing. Therefore, the instructions executed on the computer or the another programmable device provide steps for implementing a specific function in one or more procedures in the flowcharts and/or in one or more blocks in the block diagrams.

In a typical configuration, a computing device includes one or more processors (CPU), an input/output interface, a network interface, and a memory.

The memory may include a non-persistent memory, a random access memory (RAM), a non-volatile memory, and/or another form that are in a computer-readable medium, for example, a read-only memory (ROM) or a flash memory (flash RAM). The memory is an example of the computer-readable medium.

The computer-readable medium includes permanent and non-permanent, removable and non-removable media, and can store information by using any method or technology. The information can be computer-readable instructions, a data structure, a program module, or other data. Examples of a computer storage medium include but are not limited to a phase change random access memory (PRAM), a static random access memory (SRAM), a dynamic random access memory (DRAM), another type of random access memory (RAM), a read-only memory (ROM), an electrically erasable programmable read-only memory (EEPROM), a flash memory or another memory technology, a compact disc read-only memory (CD-ROM), a digital versatile disc (DVD) or another optical storage, a cassette magnetic tape, a tape and disk storage or another magnetic storage device or any other non-transmission media that can be configured to store information that a computing device can access. As described in the present specification, the computer-readable medium does not include transitory computer-readable media (transitory media) such as a modulated data signal and a carrier.

It should also be noted that the terms "include", "comprise", or any other variants thereof are intended to cover a non-exclusive inclusion, so that a process, a method, a product, or a device that includes a list of elements not only includes those elements but also includes other elements that are not expressly listed, or further includes elements inherent to such a process, method, product, or device. Without more constraints, an element preceded by "includes a ..." does not preclude the existence of additional identical elements in the process, method, product, or device that includes the element.

A person skilled in the art should understand that the implementations of the present specification can be provided as a method, a system, or a computer program product. Therefore, the present specification can use a form of hardware only implementations, software only implementations, or implementations with a combination of software and hardware. Moreover, the present specification can use a form of a computer program product that is implemented on one or more computer-usable storage media (including but not limited to a disk memory, a CD-ROM, an optical memory, etc.) that include computer-usable program code.

The present specification can be described in the general context of computer-executable instructions executed by a computer, for example, a program module. Generally, the program module includes a routine, a program, an object, a component, a data structure, etc. executing a specific task or implementing a specific abstract data type. The present specification can alternatively be practiced in distributed computing environments in which tasks are performed by remote processing devices that are connected through a communication network. In the distributed computing environments, the program module can be located in local and remote computer storage media including storage devices.

The implementations in the present specification are described in a progressive way. For same or similar parts of the implementations, mutual references can be made to the implementations. Each implementation focuses on a difference from other implementations. Particularly, the system implementations are basically similar to the method implementations, and therefore are described briefly. For related parts, references can be made to some descriptions of the method implementations.

The above-mentioned descriptions are merely some implementations of the present specification, and are not intended to limit the present specification. A person skilled in the art can make various variations and changes to the present specification. Any modification, equivalent replacement, and improvement made in the spirit and principle of the present specification shall fall within the scope of the claims in the present specification.

## Claims

1. A test device, the test device comprising:
a field programmable gate array (FPGA) chip, and
a power supply,
wherein the power supply is configured to supply power to the test device; and
wherein the FPGA chip is configured to:
receive a test instruction,
generate a control signal based on the test instruction, and
control, based on the control signal, a target power supply that supplies power to a microcontroller unit (MCU) under test to generate a voltage glitch, so as to test the MCU under test.

2. The test device according to claim 1, further comprising a programmable power supply, wherein the programmable power supply is configured to supply power to the MCU under test.

3. The test device according to claim 2, wherein the FPGA chip is configured to control, based on the control signal, the programmable power supply to generate the voltage glitch.

4. The test device according to claim 1, further comprising an MCU interface; and
the FPGA chip is configured to send, through the MCU interface, a target signal to the MCU under test, wherein the target signal includes at least one of a restart signal for restarting the MCU under test or a reset signal for resetting the MCU under test.

5. The test device according to claim 4, wherein the FPGA chip is configured to generate the control signal through the MCU interface, so as to control, based on the control signal, the target power supply to generate the voltage glitch.

6. The test device according to claim 1, further comprising a transmission interface,
wherein the FPGA chip is configured to receive, through the transmission interface, a test instruction that is sent by a host computer.

7. The test device according to claim 6, further comprising a data transmission unit, wherein the FPGA chip is configured to:
obtain, by using the data transmission unit from the MCU under test, response data generated by the MCU under test in response to the voltage glitch generated by the target power supply, and
send the response data to the host computer by using the data transmission unit.

8. The test device according to claim 7, further comprising a storage unit;
the storage unit is configured to store at least a part of the response data when a data size of the response data exceeds a threshold data size; and
the FPGA chip is configured to: read data stored in the storage unit, and send the read data to the host computer through the transmission interface.

9. A test system, comprising a host computer, a test device, and an MCU under test, wherein the test device includes an FPGA chip, a power supply, and a transmission interface;
the power supply is configured to supply power to the test device;
the host computer is configured to send a test instruction to the FPGA chip in the test device through the transmission interface; and
the test device is configured to:
receive the test instruction,
generate a control signal based on the test instruction by using the FPGA chip, and
control, based on the control signal, a target power supply that supplies power to the MCU under test to generate a voltage glitch, so as to test the MCU under test.

10. The test system according to claim 9, wherein the test device further includes a data transmission unit; and
the test device is configured to:
obtain, by using the data transmission unit from the MCU under test, response data generated by the MCU under test in response to the voltage glitch generated by the target power supply, and
send the response data to the host computer by using the data transmission unit through the FPGA chip.

11. The test system according to claim 10, wherein the test device further includes a storage unit;
the storage unit is configured to store at least a part of the response data when a data size of the response data exceeds a threshold data size; and
the FPGA chip is configured to: read data stored in the storage unit, and send the read data to the host computer through the transmission interface.

12. The test system according to claim 9, wherein the host computer is configured to send a pre-stored test logic program to the test device through the transmission interface before sending the test instruction; and
the test device stores the test logic program in the FPGA chip, so that when the test instruction is received, a test task for the MCU under test is executed by using the test logic program.

13. A test method, being applied to an FPGA chip disposed in a test device, and comprising:
receiving a test instruction;
generating a control signal based on the test instruction; and
controlling, based on the control signal, a target power supply that supplies power to an MCU under test to generate a voltage glitch, so as to test the MCU under test.

14. A test apparatus, the apparatus being disposed in a test device, and comprising:
a receiving module, configured to receive a test instruction;
a generation module, configured to generate a control signal based on the test instruction; and
a control module, configured to control, based on the control signal, a target power supply that supplies power to an MCU under test to generate a voltage glitch, so as to test the MCU under test.

15. A computer-readable storage medium, storing a computer program, wherein when the computer program is executed by a processor, the method according to claim 13 is implemented.
